# EUROPÄISCHE PATENTANMELDUNG

(11) **EP 1 383 367 A1**
(43) Veröffentlichungstag der Anmeldung: **21.01.2004**
(21) Anmeldenummer: 02405625.1
(22) Anmeldetag: 19.07.2002
(51) Int. Cl.: H05K 5/02

(54) **Frontgriff für Gehäuse und Baugruppenträger**

(71) Anmelder: ELMA Electronic AG, 8620 Wetzikon (CH)
(72) Erfinder: Hauser, Christoph, 8630 Rüti (CH); Heussi, Georg, 8645 Jona (CH)
(74) Vertreter: Sulzer Management AG

(57) **Zusammenfassung**

Der Frontgriff für Gehäuse und Baugruppenträger umfasst zwei getrennt herstellbare Griffteile (1, 2), die je einen Befestigungsbereich (12, 22) zum Befestigen am Gehäuse beziehungsweise Baugruppenträger aufweisen und je einen vom Befestigungsbereich beabstandet angeordneten Verbindungsbereich (14, 24). Weiter umfasst der Frontgriff einen dritten getrennt herstellbaren Griffteil (3), der länglich geformt ist und Verbindungsbereiche (34.1, 34.2) zum Verbinden mit dem ersten und dem zweiten Griffteil (1, 2) aufweist.

## Beschreibung

Die Erfindung betrifft einen Frontgriff für Gehäuse und Baugruppenträger gemäss Oberbegriff von Anspruch 1 und ein Verfahren zum Herstellen eines solchen Frontgriffs.

Herkömmliche Frontgriffe für Gehäuse und Baugruppenträger werden mit Hilfe eines Massenherstellungsverfahren wie beispielsweise Spritzgiessen in einem Stück hergestellt. Normalerweise sind die Frontgriffe bezüglich ihrer Abmessungen an eine bestimmte, meist normierte Gehäusehöhe beziehungsweise Baugruppenträgerhöhe angepasst. 19"-Gehäuse oder 19"-Baugruppenträger mit Abmessungen gemäss IEC 60297 werden beispielsweise in diskreten Höhen von 2 bis 7 und mehr Höheneinheiten gefertigt. Für die Herstellung der dazu passenden Frontgriffe wird für jede Gehäusehöhe ein eigenes Werkzeug, beispielsweise ein Spritzgusswerkzeug benötigt. Besonders in den Fällen, in denen lediglich kleinere bis mittlere Stückzahlen gefertigt werden, beispielsweise wenn für eine Anwendung ein Gehäuse oder Baugruppenträger mit anwendungsspezifischen Abmessungen eingesetzt wird, fallen die Kosten für die Beschaffung eines speziellen Werkzeuges für die Herstellung passender Frontgriffe schwer ins Gewicht.

Aufgabe der Erfindung ist es, einen Frontgriff für Gehäuse und Baugruppenträger zur Verfügung zu stellen, dessen Länge einfach an unterschiedliche Gehäuseabmessungen angepasst werden kann, und der sich auch in kleineren und mittleren Stückzahlen wirtschaftlich herstellen lässt.

Eine weitere Aufgabe der Erfindung ist es, ein Verfahren zum Herstellen eines derartigen Frontgriffs zur Verfügung zu stellen.

Diese Aufgabe wird erfindungsgemäss durch den in Anspruch 1 definierten Frontgriff und das in Anspruch 8 definierte Herstellungsverfahren gelöst.

Der erfindungsgemässe Frontgriff für ein Gehäuse oder einen Baugruppenträger umfasst mindestens zwei getrennt herstellbare Griffteile, nämlich mindestens einen ersten sowie einen zweiten Griffteil, die je einen Befestigungsbereich zum Befestigen am Gehäuse beziehungsweise Baugruppenträger aufweisen. Weiter weisen der erste und der zweite Griffteil je einen vom Befestigungsbereich beabstandet angeordneten Verbindungsbereich auf. Die Griffteile sind über die Verbindungsbereiche und einen länglich geformten Bereich miteinander verbunden, wobei der länglich geformte Bereich zwischen den beiden Befestigungsbereichen sowie beabstandet von diesen angeordnet ist und entweder Teil des zweiten Griffteiles ist oder einen dritten Griffteil bildet, der ebenfalls getrennt herstellbar ist und Verbindungsbereiche zum Verbinden mit dem ersten und dem zweiten Griffteil aufweist.

Vorzugsweise weist das Gehäuse oder der Baugruppenträger anwendungsspezifische Abmessungen auf, und die Länge des Frontgriffs ist durch Wahl der Länge des länglichen Bereiches an die Gehäuseabmessungen anpassbar, beispielsweise indem der längliche Bereich Überlänge aufweist und auf die passende Länge kürzbar ist. Vorzugsweise ist der längliche Bereich als Längsprofil ausgebildet.

Vorzugsweise passen die Verbindungsbereiche jeweils paarweise zusammen, wobei jeweils ein Verbindungsbereich von zwei zusammenpassenden Verbindungsbereichen mit einem oder mehreren vorstehenden Elementen, beispielsweise Nocken ausgestattet ist und der andere Verbindungsbereich mit einer oder mehreren dazu passenden Vertiefungen, so dass die Griffteile mittels der vorstehenden Elemente und der Vertiefungen zusammenfügbar sind. Vorzugsweise sind die Vertiefungen und die vorstehenden Elemente in Längsrichtung des länglichen Bereiches angeordnet.

Vorzugsweise sind die vorstehenden Elemente mittels Presssitz in die Vertiefungen einsetzbar und vorzugsweise sind die vorstehenden Elemente und die Vertiefungen derart ausgebildet, dass die Griffteile gegen gegenseitiges Verdrehen gesichert sind, beispielsweise indem die paarweise zusammenpassenden Verbindungsteile mit je mindestens zwei vorstehenden Elementen und Vertiefungen ausgestattet sind.

In dem erfindungsgemässen Verfahren zum Herstellen eines Frontgriffes für ein Gehäuse oder einen Baugruppenträger werden mindestens zwei Griffteile separat hergestellt und die Griffteile in mindestens einem weiteren Arbeitsschritt zum Frontgriff zusammengefügt. Vorzugsweise werden die mindestens zwei Griffteile mittels Presssitz und/oder Kleben und/oder Schweissen zusammengefügt.

Der erfindungsgemässe Frontgriff für ein Gehäuse oder einen Baugruppenträger und das erfindungsgemässen Verfahren zum Herstellen eines solchen Frontgriffes haben den Vorteil, dass bereits mit einem oder zwei Werkzeugen Frontgriffe für beliebige, anwendungsspezifische Gehäusehöhen beziehungsweise Baugruppenträgerhöhen hergestellt werden können. Vor allem für kleinere und mittlere Serien ist es ein entscheidender Vorteil, dass nicht für jede zu fertigende Grifflänge ein spezielles Werkzeug beschafft werden muss. Da der erfindungsgemässe Frontgriff aus mindestens zwei Griffteilen zusammenfügbar ist, kann einer der Griffteile mit Überlänge hergestellt und anschliessend auf die passende Länge gekürzt werden oder es kann ein dritter Griffteil vorgesehen werden, der beispielsweise einen Abschnitt passender Länge eines extrudierten Längsprofils umfasst.

Weitere vorteilhafte Ausführungsformen gehen aus den abhängigen Ansprüchen und der Zeichnung hervor.

Im Folgenden wird die Erfindung an Hand der Ausführungsbeispiele und an Hand der Zeichnung näher erläutert. Es zeigen:
- Fig. 1: eine Schrägansicht eines ersten Ausführungsbeispiels zur vorliegenden Erfindung mit drei separat herstellbaren Griffteilen,

- Fig. 2: eine Schrägansicht eines zweiten Ausführungsbeispiels zur vorliegenden Erfindung mit zwei separat herstellbaren Griffteilen,
- Fig. 3: eine Schrägansicht des ersten und zweiten Ausführungsbeispiels in zusammengefügtem Zustand.

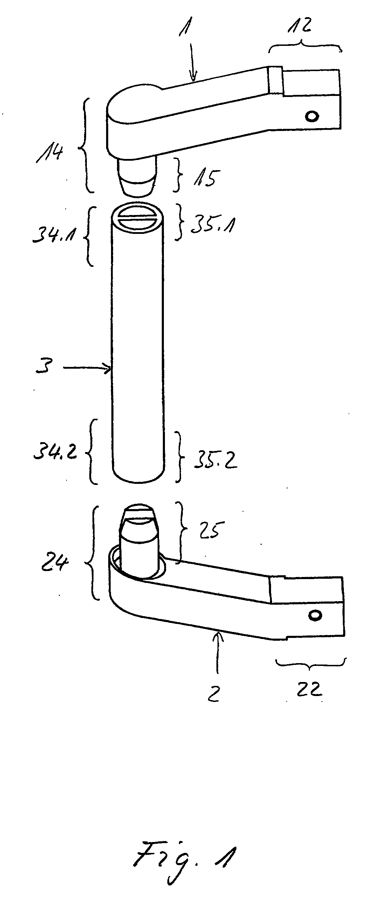

In einem ersten Ausführungsbeispiel, welches in Fig. 1 gezeigt ist, umfasst der erfindungsgemässe Frontgriff drei separat herstellbare Griffteile 1, 2, 3, welche beispielsweise als Metall- und/oder Kunststoffformteile ausgebildet sein können. Ein erster und ein zweiter separat herstellbarer Griffteil 1, 2 weisen je einen Befestigungsbereich 12, 22 zum Befestigen des Frontgriffs an einem Gehäuse beziehungsweise Baugruppenträger auf und je einen vom Befestigungsbereich 12, 22 beabstandet angeordneten Verbindungsbereich 14, 24. Ein dritter separat herstellbarer Griffteil 3 ist länglich geformt und zwischen dem ersten und zweiten Griffteil 1, 1 angeordnet. Der dritte Griffteil 3 weist zwei beabstandet angeordnete Verbindungsbereiche 34.1, 34.2 auf, über welche er mit dem jeweiligen Verbindungsbereich 14, 24 des ersten beziehungsweise des zweiten Griffteils verbunden ist.

Der Frontgriff des ersten Ausführungsbeispiels ist durch passende Wahl der Länge des dritten Griffteiles 3 an beliebige anwendungsspezifische Gehäusehöhen beziehungsweise Baugruppenträgerhöhen anpassbar. In einer bevorzugten Ausführungsvariante ist der dritte Griffteil als Längsprofil ausgebildet. Längsprofile können beispielsweise mittels Extrudieren in grösseren Längen hergestellt und auf einem Drehautomaten zu länglich geformten Griffteilen passender Länge weiterverarbeitet werden.

Zweckmässigerweise passen die Verbindungsbereiche 14, 24, 34.1, 34.2 jeweils paarweise zusammen, wobei jeweils ein Verbindungsbereich von zwei zusammenpassenden Verbindungsbereichen mit einem oder mehreren vorstehenden Elementen, beispielsweise Nocken 15, 25 ausgestattet ist und der andere Verbindungsbereich mit einer oder mehreren dazu passenden Vertiefungen 35.1, 35.2, so dass die Griffteile 1, 2, 3 mittels der vorstehenden Elemente 15, 25 und der Vertiefungen 35.1, 35.2 zusammenfügbar sind. In einer bevorzugten Ausführungsvariante sind die Vertiefungen 35.1, 35.2 und die vorstehenden Elemente 15, 25 in Längsrichtung des dritten Griffteiles angeordnet. In einer weiteren Ausführungsvariante sind die vorstehenden Elemente 15, 25 mittels Presssitz in die Vertiefungen 35.1, 35.2 einsetzbar.

In einer weiteren bevorzugten Ausführungsvariante sind die vorstehenden Elemente 15, 25 und die Vertiefungen 35.1, 35.2 derart ausgebildet, dass die Griffteile gegen gegenseitiges Verdrehen gesichert sind. In dem in Fig. 1 dargestellten Ausführungsbeispiel umfassen der erste und der zweite Griffteil je einen Verbindungsbereich 14, 24 mit einem Doppelnocken 15, 25, welcher durch einen Längsschlitz in zwei gleich grosse Hälften unterteilt ist. Der dritte Griffteil umfasst zwei Verbindungsbereiche 34.1, 34.2 mit Vertiefungen 35.1, 35.2, welche durch ein rohrförmiges Längsprofil gebildet werden, dass durch eine längs angeordnete Trennwand in zwei gleiche Hälften geteilt ist. Damit stehen pro Verbindungsbereich 34.1, 34,2 zwei Vertiefungen zur Aufnahme des oben beschriebenen Doppelnockens zur Verfügung. Beim Zusammenfügen greift die Trennwand in den Schlitz der Doppelnocke, sodass die Griffteile gegen Verdrehen gesichert sind. Selbstverständlich kann die Sicherung gegen Verdrehen auch durch eine andere Formgebung der Verbindungsbereiche erreicht werden, beispielsweise durch einen Vierkantnocken und eine entsprechende viereckige Vertiefung.

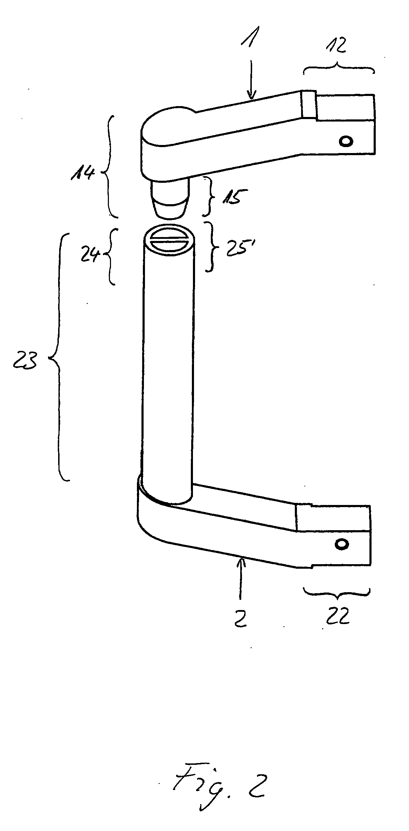

In einem zweiten Ausführungsbeispiel, welches in Fig. 2 gezeigt ist, umfasst der erfindungsgemässe Frontgriff zwei separat herstellbare Griffteile 1, 2. Ein erster und ein zweiter Griffteil 1, 2 weisen je einen Befestigungsbereich 12, 22 zum Befestigen des Frontgriffs an einem Gehäuse beziehungsweise Baugruppenträger auf und je einen vom Befestigungsbereich 12, 22 beabstandet angeordneten Verbindungsbereich 14, 24. Der zweite Griffteil 2 umfasst zusätzlich einen länglich geformten Bereich 23, welcher zwischen den beiden Befestigungsbereichen 12, 22 sowie beabstandet von diesen angeordnet ist, und welcher über die Verbindungsbereiche 14, 24 mit dem ersten Griffteil 1 verbunden ist.

Der Frontgriff des zweiten Ausführungsbeispiels ist durch passende Wahl der Länge des länglichen Bereiches 23 an beliebige anwendungsspezifische Gehäusehöhen beziehungsweise Baugruppenträgerhöhen anpassbar, beispielsweise indem der längliche Bereich Überlänge aufweist und auf die passende Länge kürzbar ist. In einer bevorzugten Ausführungsvariante ist der längliche Bereich als Längsprofil ausgebildet.

Zweckmässigerweise passen die Verbindungsbereiche 14, 24 derart zusammen, dass sie einfach zusammengefügt werden können, beispielsweise indem jeweils ein Verbindungsbereich mit einem oder mehreren vorstehenden Elementen, beispielsweise Nocken 15 ausgestattet ist und der andere Verbindungsbereich mit einer oder mehreren dazu passenden Vertiefungen 25', sodass die Griffteile 1, 2 mittels der vorstehenden Elemente 15 und der Vertiefungen 25' zusammenfügbar sind. In einer bevorzugten Ausführungsvariante sind die Vertiefungen 25' und die vorstehenden Elemente 15 in Längsrichtung des länglichen Bereiches 23 angeordnet. In einer weiteren Ausführungsvariante sind die vorstehenden Elemente 15 mittels Presssitz in die Vertiefungen 25' einsetzbar.

Ein Schutz gegen gegenseitiges Verdrehen der Griffteile 1, 2 kann in der selben Weise ausgeführt sein, wie oben im Rahmen des ersten Ausführungsbeispiel beschrieben.

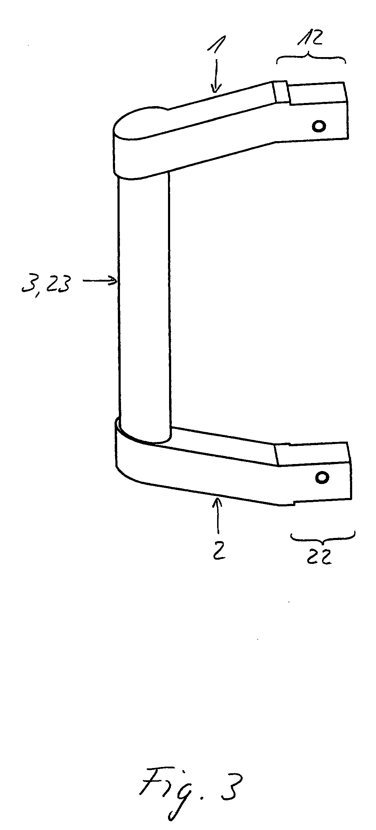

In einer bevorzugten Ausführungsform des erfindungsgemässen Verfahrens zum Herstellen eines Frontgriffes für ein Gehäuse oder einen Baugruppenträger, werden mindestens zwei Griffteile 1, 2 separat hergestellt, beispielsweise mittels eines Massenherstellungsverfahrens wie Druckguss, Spritzguss oder Formpressen, und die Griffteile in mindestens einem weiteren Arbeitsschritt zum Frontgriff zusammengefügt. Fig. 3 zeigt den Frontgriff des ersten und zweiten Ausführungsbeispiels in zusammengefügten Zustand. In einer Ausführungsvariante werden die Griffteile mittels Presssitz und/oder Kleben und/oder Schweissen zusammengefügt.

In einer bevorzugten Ausführungsvariante umfasst das Verfahren die Herstellung eines länglichen Bereichs 3, 23, welcher entweder Teil des zweiten Griffteiles 2 ist oder einen dritten Griffteil 3 bildet, der ebenfalls getrennt hergestellt wird. Die Länge des länglichen Bereichs 3, 23 wird zweckmässigerweise so gewählt, dass der Frontgriff nach dem Zusammenfügen der Griffteile die für die vorgesehene Gehäuse- oder Baugruppenträgerhöhe passende Gesamtlänge aufweist. Dazu kann der längliche Bereich beispielsweise mit Überlänge hergestellt und anschliessend auf die gewählte Länge gekürzt werden. In einer weiteren bevorzugten Ausführungsvariante ist der längliche Bereich als Längsprofil ausgebildet, welches beispielsweise mittels Extrudieren in grösseren Längen hergestellt und anschliessend zu länglich geformten Griffteilen passender Länge weiterverarbeitet werden kann.

Mit Hilfe des erfindungsgemässen Verfahrens ist es möglich, Frontgriffe in unterschiedlichen Längen herzustellen, ohne dass für jede Länge ein spezielles Werkzeug beschafft werden muss.

## Patentansprüche

1. Frontgriff für ein Gehäuse oder einen Baugruppenträger, welcher Frontgriff zwei getrennt herstellbare Griffteile (1, 2) umfasst, nämlich einen ersten sowie einen zweiten Griffteil (1, 2), die je einen Befestigungsbereich (12, 22) zum Befestigen am Gehäuse beziehungsweise Baugruppenträger aufweisen, wobei
- der erste und der zweite Griffteil (1, 2) je einen vom Befestigungsbereich (12, 22) beabstandet angeordneten Verbindungsbereich (14, 24) aufweisen,
- die Griffteile (1, 2) über die Verbindungsbereiche (14, 24) und einen länglich geformten Bereich (3, 23) miteinander verbunden sind,
- der länglich geformte Bereich (3, 23) zwischen den beiden Befestigungsbereichen (12, 22) sowie beabstandet von diesen angeordnet ist und
- der länglich geformte Bereich (3, 23) entweder Teil des zweiten Griffteiles (2) ist oder einen dritten Griffteil (3) bildet, der ebenfalls getrennt herstellbar ist und Verbindungsbereiche (34.1, 34.2) zum Verbinden mit dem ersten und dem zweiten Griffteil (1, 2) aufweist.

2. Frontgriff nach Anspruch 1, wobei das Gehäuse oder der Baugruppenträger anwendungsspezifische Abmessungen aufweisen, und wobei die Länge des Frontgriffs durch Wahl der Länge des länglichen Bereiches (3, 23) an die Gehäuseabmessungen anpassbar ist.

3. Frontgriff nach Anspruch 1 oder 2, wobei der längliche Bereich (3, 23) als Längsprofil ausgebildet ist.

4. Frontgriff nach einem der Ansprüche 1 bis 3, wobei die Verbindungsbereiche (14, 24, 34.1, 34.2) jeweils paarweise zusammenpassen, und wobei jeweils ein Verbindungsbereich von zwei zusammenpassenden Verbindungsbereichen mit einem oder mehreren vorstehenden Elementen (15, 25) ausgestattet ist und der andere Verbindungsbereich mit einer oder mehreren dazu passenden Vertiefungen (25', 35.1, 35.2), so dass die Griffteile mittels der vorstehenden Elemente (15, 25) und der Vertiefungen (25', 35.1, 35.2) zusammenfügbar sind.

5. Frontgriff nach Anspruch 4, wobei die Vertiefungen (25', 35.1, 35.2) und die vorstehenden Elemente (15, 25) in Längsrichtung des länglichen Bereiches (3, 23) angeordnet sind.

6. Frontgriff nach einem der Ansprüche 4 bis 5, wobei die vorstehenden Elemente (15, 25) mittels Presssitz in die Vertiefungen (25', 35.1, 35.2) einsetzbar sind.

7. Frontgriff nach einem der Ansprüche 1 bis 6, wobei die vorstehenden Elemente(15, 25) und die Vertiefungen (25', 35.1, 35.2) derart ausgebildet sind, dass die Griffteile gegen gegenseitiges Verdrehen gesichert sind.

8. Verfahren zum Herstellen eines Frontgriffes für ein Gehäuse oder einen Baugruppenträger, **dadurch gekennzeichnet,**
**dass** mindestens zwei Griffteile (1, 2) separat hergestellt werden, und dass diese in mindestens einem weiteren Arbeitsschritt zum Frontgriff zusammengefügt werden.

9. Verfahren nach Anspruch 8, bei welchem die mindestens zwei Griffteile mittels Presssitz und/oder Kleben und/oder Schweissen zusammengefügt werden.
